# EUROPÄISCHE PATENTSCHRIFT

(11) **EP 1 163 676 B1**
(45) Veröffentlichungstag und Bekanntmachung des Hinweises auf die Patenterteilung: **11.12.2002**
(21) Anmeldenummer: 00910562.8
(22) Anmeldetag: 01.03.2000
(51) Int. Cl.: G11C 11/16

(54) **SPEICHERZELLENANORDNUNG UND VERFAHREN ZU DEREN HERSTELLUNG**
STORAGE CELL ARRAY AND METHOD FOR THE PRODUCTION THEREOF
ENSEMBLE CELLULES MEMOIRE ET SON PROCEDE DE PRODUCTION

(30) Priorität: 19.03.1999 DE 19912523
(43) Veröffentlichungstag der Anmeldung: 19.12.2001
(73) Patentinhaber: Infineon Technologies AG, 81669 München (DE)
(72) Erfinder: GOEBEL, Bernd, D-81735 München (DE); SCHWARZL, Siegfried, D-85579 Neubiberg (DE)
(74) Vertreter: Epping Hermann & Fischer
(86) Internationale Anmeldenummer: DE0000590
(87) Internationale Veröffentlichungsnummer: WO00057423

(56) Entgegenhaltungen:
- DE-A- 19 744 095
- US-A- 3 972 059
- US-A- 5 640 343
- PATENT ABSTRACTS OF JAPAN vol. 1998, no. 13, 30. November 1998 (1998-11-30) & JP 10 222817 A (HITACHI LTD), 21. August 1998 (1998-08-21)

## Beschreibung

Die Erfindung betrifft eine Speicherzellenanordnung mit Speicherelementen mit einer Schichtstruktur mit magnetoresistivem Effekt.

Aus der Technologieanalyse XMR-Technologien, Technologiefrüherkennung, Verfasser Stefan Mengel, Herausgeber VDI-Technologiezentrum Physikalische Technologien, sind Schichtstrukturen mit magnetoresistivem Effekt bekannt. Je nach Aufbau der Schichtstruktur wird unterschieden zwischen GMR-Element, TMR-Element, AMR-Element und CMR-Element.

Der Begriff GMR-Element wird in der Fachwelt für Schichtstrukturen verwendet, die mindestens zwei ferromagnetische Schichten und eine dazwischen angeordnete nicht magnetische leitende Schicht aufweisen und den sogenannten GMR-(giantmagnetoresistance) Effekt, das heißt einen im Vergleich zum AMR-(anisotropic-magnetoresistance) Effekt großen magnetoresistiven Effekt zeigen. Unter dem GMR-Effekt wird die Tatsache verstanden, daß der elektrische Widerstand des GMR-Elements abhängig davon ist, ob die Magnetisierungen in den beiden ferromagnetischen Schichten parallel oder antiparallel ausgerichtet sind.

Der Begriff TMR-Element wird in der Fachwelt für "Tunneling magnetoresistance"-Schichtstrukturen verwendet, die mindestens zwei ferromagnetische Schichten und eine dazwischen angeordnete isolierende, nicht magnetische Schicht aufweisen. Die isolierende Schicht ist dabei so dünn, daß es zu einem Tunnelstrom zwischen den beiden ferromagnetischen Schichten kommt. Diese Schichtstrukturen zeigen ebenfalls einen magnetoresistiven Effekt, der durch einen spinpolarisierten Tunnelstrom durch die zwischen den beiden ferromagnetischen Schichten angeordnete isolierende, nicht magnetische Schicht bewirkt wird. Auch in diesem Fall ist der elektrische Widerstand des TMR-Elements abhängig davon, ob die Magnetisierungen in den beiden ferromagnetischen Schichten parallel oder antiparallel ausgerichtet sind.

Der AMR-Effekt äußert sich dadurch, daß der Widerstand in magnetisierten Leitern parallel und senkrecht zur Magnetisierungsrichtung verschieden ist. Er ist ein Volumeneffekt und tritt somit in ferromagnetischen Einfachschichten auf.

Ein weiterer Magnetowiderstandseffekt, der wegen seiner Größe (ΔR/R = 100 bis 400 % bei Raumtemperatur) Colossal Magnetoresistance Effekt genannt wird, erfordert wegen seiner hohen Koerzitivkräfte ein hohes Magnetfeld zum Umschalten zwischen den Magnetisierungszuständen.

In US 5 640 343 wird eine sogenannte MRAM-Speicherzellenanordnung beschrieben, bei der Speicherzellen zwischen zwei übereinander angeordneten Lagen metallischer Leitungen angeordnet sind. Die Speicherzellen weisen jeweils eine Diode und ein dazu in Reihe geschaltetes Speicherelement auf. Das Speicherelement weist eine Schichtstruktur mit magnetoresistivem Effekt auf. Die Diode ist eine pn-Diode oder eine Schottkydiode, die Silizium enthält. Die Schichtstruktur des Speicherelements und die Schichtstruktur der Diode sind übereinander angeordnet. Die metallischen Leitungen der ersten Lage verlaufen parallel zueinander. Die metallischen Leitungen der zweiten Lage verlaufen parallel zueinander und senkrecht zu den metallischen Leitungen der ersten Lage. Die Speicherzellen sind jeweils zwischen eine metallische Leitung der ersten Lage und eine metallische Leitung der zweiten Lage geschaltet. Die Schichtstruktur des Speicherelements besteht aus zwei ferromagnetischen Schichten und einer dazwischen angeordneten isolierenden Schicht. Der elektrische Widerstand des Speicherelements ist abhängig davon, ob die Magnetisierungsrichtungen der beiden ferromagnetischen Schichten parallel oder antiparallel zueinander sind. Zum Schreiben einer Information auf eine Speicherzelle werden den metallischen Leitungen, die mit der Speicherzelle verbunden sind, Ströme eingeprägt. Dabei werden Spannungen so gewählt, daß kein Strom durch die Speicherzelle fließt. Die durch die Ströme erzeugten magnetischen Felder addieren sich im Bereich der Speicherzelle derart, daß die Magnetisierung einer der beiden magnetischen Schichten im Magnetfeld ausgerichtet wird. Die Magnetisierungsrichtung der anderen ferromagnetischen Schicht bleibt unverändert. Diese Ausrichtung stellt die Information dar. Zum Auslesen der Information wird die Spannung der metallische Leitung, die mit der Diode verbunden ist, gesenkt und die Spannung an der metallischen Leitung, die mit dem Speicherelement verbunden ist, erhöht. An metallischen Leitungen, die mit den übrigen Speicherelementen verbunden sind, liegt dieselbe Spannung an wie an der metallischen Leitung, die mit der Diode der auszulesenden Speicherzelle verbunden ist. An den metallischen Leitungen, die mit den übrigen Dioden verbunden sind, liegt dieselbe Spannung an, wie an der metallischen Leitung, die mit dem Speicherelement der auszulesenden Speicherzelle verbunden ist. Aufgrund der Dioden in den Speicherzellen kann nur Strom durch die auszulesende Speicherzelle fließen. Der Strom hat abhängig von der auf der Speicherzelle gespeicherten Information zwei diskrete Werte, die zwei Magnetisierungszuständen des Speicherelements entsprechen.

Der Erfindung liegt das Problem zugrunde, eine Speicherzellenanordnung mit Speicherelementen mit magnetoresistivem Effekt anzugeben, die mit im Vergleich zum Stand der Technik erhöhter Packungsdichte herstellbar ist. Ferner soll ein Verfahren zur Herstellung einer solchen Speicherzellenanordnung angegeben werden.

Dieses Problem wird durch eine Speicherzellenanordnung gelöst, bei der mindestens drei Lagen metallischer Leitungen und zwei Lagen von Speicherzellen vorgesehen sind, die alternierend übereinander angeordnet sind. Die Speicherzellen weisen jeweils eine Diode und ein dazu in Reihe geschaltetes Speicherelement auf. Das Speicherelement weist eine Schichtstruktur mit magnetoresistivem Effekt auf. Die Diode weist eine Schichtstruktur auf, die aus mindestens zwei Metallschichten und aus einer dazwischen angeordneten isolierenden Schicht besteht. Die Schichtstruktur des Speicherelements und die Schichtstruktur der Diode sind übereinander angeordnet. Die metallischen Leitungen von jeweils einer der Lagen verlaufen parallel zueinander. Die metallischen Leitungen von zueinander benachbarten Lagen verlaufen quer zueinander. Die Speicherzellen sind jeweils zwischen eine metallische Leitung einer Lage und eine metallische Leitung einer dieser Lage benachbarten Lage geschaltet.

Das Problem wird ferner gelöst durch ein Verfahren zur Herstellung einer Speicherzellenanordnung, bei dem eine erste Lage metallischer Leitungen, die parallel zueinander verlaufen, erzeugt wird. Über der ersten Lage der metallischen Leitungen wird eine erste Lage von Speicherzellen so erzeugt, daß diese Speicherzellen mit den metallischen Leitungen der ersten Lage verbunden sind. Für die Speicherzellen der ersten Lage wird jeweils ein Speicherelement und eine dazu in Reihe geschaltete Diode erzeugt. Für die Diode wird eine Schichtstruktur erzeugt, die aus mindestens zwei Metallschichten und aus einer dazwischen angeordneten isolierenden Schicht besteht. Für das Speicherelement wird eine Schichtstruktur mit magnetoresistivem Effekt erzeugt. Die Schichtstruktur des Speicherelements und die Schichtstruktur der Diode werden übereinander erzeugt. Über der ersten Lage der Speicherzellen wird eine zweite Lage metallischer Leitungen, die parallel zueinander und quer zu den metallischen Leitungen der ersten Lage verlaufen, so erzeugt, daß die Speicherzellen der ersten Lage jeweils zwischen eine metallische Leitung der ersten Lage und eine metallische Leitung der zweiten Lage geschaltet sind. Über der zweiten Lage der metallischen Leitungen werden entsprechend den Speicherzellen der ersten Lage aufgebaute Speicherzellen einer zweiten Lage erzeugt. Über der zweiten Lage der Speicherzellen wird eine dritte Lage metallischer Leitungen, die parallel zueinander und quer zu den metallischen Leitungen der zweiten Lage verlaufen, so erzeugt, daß die Speicherzellen der zweiten Lage jeweils zwischen eine metallische Leitung der zweiten Lage und eine metallische Leitung der dritten Lage geschaltet sind.

Da die Speicherzellen in mindestens zwei übereinander gestapelten Lagen angeordnet sind, sinkt der Flächenbedarf pro Speicherelement und die Packungsdichte der Speicherzellenanordnung wird erhöht. Je größer die Anzahl der Lagen der Speicherzellen, die übereinander gestapelt sind, desto höher ist die erzielbare Packungsdichte. Jede Lage von Speicherzellen ist dabei zwischen zwei Lagen metallischer Leitungen angeordnet. Die metallischen Leitungen der einen Lage verlaufen quer zu den metallischen Leitungen der anderen Lage. Die metallischen Leitungen sind jeweils mit minimalen Abmessungen und Abständen von einer minimalen, in der verwendeten Technologie herstellbaren Strukturgröße F herstellbar, so daß sich pro Lage ein Flächenbedarf pro Speicherzelle von 4F² ergibt. Insgesamt ergibt sich in der Speicherzellenanordnung bei n Lagen ein Flächenbedarf von 4F²/n pro Speicherzelle.

Die Diode ist eine Tunneldiode, bei der Elektronen durch die isolierende Schicht in eine Richtung leichter tunneln als in die andere. Zur Erzeugung der Diode sind keine hohen Temperaturen erforderlich, die metallische Leitungen, die unter der Diode liegen, zerstören könnten.

Das Vorsehen der Dioden verhindert, daß beim Auslesen von Information einer Speicherzelle einer Lage Ströme durch Speicherzellen einer dieser Lage benachbarten Lage fließen. Darüber hinaus bewirkt das Vorsehen der Dioden, daß ein Strom zwischen den metallischen Leitungen, die mit der auszulesenden Speicherzelle verbunden sind, ausschließlich durch die auszulesende Speicherzelle fließt. Dies ist vorteilhaft, da die Größe des Stroms dadurch unabhängig von auf anderen Speicherzellen gespeicherten Informationen ist und lediglich die auszulesende Information wiedergibt.

Der Prozeßaufwand zur Erzeugung der Speicherzellenanordnung ist besonders klein, wenn eine Maske zur Erzeugung der metallischen Leitungen einer Lage und eine Maske zur Erzeugung der metallischen Leitungen einer benachbarten Lage zugleich der Erzeugung der zwischen diesen Lagen metallischer Leitungen angeordneten Speicherzellen dienen.

Beispielsweise wird eine erste leitende Schicht und darüber Schichten zur Erzeugung der ersten Lage der Speicherzellen erzeugt. Die Schichten zur Erzeugung der ersten Lage der Speicherzellen und die erste leitende Schicht werden mit Hilfe einer streifenförmigen ersten Maske so strukturiert, daß aus der ersten Schicht die erste Lage der metallischen Leitungen erzeugt wird. Anschließend wird isolierendes Material abgeschieden und planarisiert, so daß voneinander getrennte streifenförmige erste isolierende Strukturen erzeugt werden.

Eine zweite leitende Schicht und Schichten zur Erzeugung der zweiten Lage der Speicherzellen werden aufgebracht. Die Schichten zur Erzeugung der zweiten Lage der Speicherzellen, die zweite leitende Schicht und die Schichten zur Erzeugung der ersten Lage der Speicherzellen werden mit Hilfe einer streifenförmigen zweiten Maske so strukturiert, daß aus der zweiten Schicht die zweite Lage der metallischen Leitungen erzeugt wird, und daß aus den Schichten zur Erzeugung der ersten Lage der Speicherzellen die Speicherzellen der ersten Lage erzeugt werden. Die Speicherzellen der ersten Lage werden folglich in zwei Schritten durch Strukturierung der entsprechenden Schichten erzeugt. Der erste Schritt erfolgt bei der Erzeugung der ersten Lage der metallischen Leitungen und der zweite Schritt erfolgt bei der Erzeugung der zweiten Lage der metallischen Leitungen. Anschließend wird isolierendes Material abgeschieden und planarisiert, so daß voneinander getrennte streifenförmige zweite isolierende Strukturen erzeugt werden.

Anschließend wird eine dritte leitende Schicht aufgebracht. Die dritte leitende Schicht und die Schichten zur Erzeugung der zweiten Lage der Speicherzellen werden streifenförmig so strukturiert, daß aus der dritten Schicht die dritte Lage der metallischen Leitungen erzeugt wird und daß aus den Schichten zur Erzeugung der zweiten Lage der Speicherzellen die Speicherzellen der zweiten Lage erzeugt werden. Die Speicherzellen der zweiten Lage werden folglich durch Strukturierung der entsprechenden Schichten in zwei Prozeßschritten erzeugt. Der erste Schritt erfolgt bei der Erzeugung der zweiten Lage der metallischen Leitungen und der zweite Schritt erfolgt bei der Erzeugung der dritten Lage der metallischen Leitungen. Auf diese Weise können beliebig viele Lagen von Speicherzellen und metallischen Leitungen erzeugt werden.

Besonders gute elektrische Eigenschaften der Diode lassen sich erzielen, wenn die Differenz der Austrittsarbeit der einen Metallschicht und der Austrittsarbeit der anderen Metallschicht möglichst groß ist. In diesem Fall ist die Asymmetrie der Tunneleffekte in der Diode besonders groß, d.h. Elektronen tunneln in die eine Richtung wesentlich leichter als in die andere. Aluminium hat eine besonders niedrige Austrittsarbeit. Die eine Metallschicht besteht folglich vorzugsweise aus Aluminium. Andere Materialien mit niedriger Austrittsarbeit sind jedoch ebenfalls geeignet. Die andere Metallschicht besteht vorzugsweise aus Platin, da Platin eine besonders hohe Austrittsarbeit hat. Andere Materialien mit hoher Austrittsarbeit, wie z.B. Wolfram, sind jedoch ebenfalls geeignet.

Zur Erzeugung der isolierenden Schicht kann das Aluminium oxidiert werden.

Die metallischen Leitungen können zum Beispiel aus Cu, AlSiCu oder Metallsilizid bestehen.

Zur Prozeßvereinfachung ist es vorteilhaft, wenn eine der zwei Metallschichten der Diode Teil einer der metallischen Leitungen ist. In diesem Fall bestehen die metallischen Leitungen vorzugsweise aus Aluminium.

Zwischen der Schichtstruktur der Diode und der Schichtstruktur des Speicherelements kann eine Diffusionsbarriere aus zum Beispiel TiN angeordnet sein.

Als Speicherelement sind alle bekannten TMR-Elemente und GMR-Elemente geeignet. Darüber hinaus sind alle XMR-Elemente geeignet, die zwei Magnetisierungszustände mit unterschiedlichem Widerstand aufweisen, zwischen denen durch Anlegen eines Magnetfeldes, dessen Höhe für die Speicheranwendung verträglich ist, hin- und hergeschaltet werden kann.

Vorzugsweise besteht die Schichtstruktur des Speicherelements mindestens aus zwei magnetischen Schichten und einer dazwischen angeordneten nichtmagnetischen Schicht. Die Speicherelemente weisen jeweils zwei Magnetisierungszustände auf.

Die nichtmagnetische Schicht ist vorzugsweise eine isolierende Schicht (TMR-Element), weil dadurch höhere Elementwiderstände (= 100 kΩ) erzielbar sind, die hinsichtlich Leistungsverbrauch und Signal/Rauschverhältnis günstiger sind. Als Materialien für die magnetischen Schichten eignen sich zum Beispiel Ni, Fe, Co, Cr, Mn, Gd, Dy und Legierungen daraus, wie NiFe, NiFeCo, CoFe, CoCrFe, sowie MuBi, BiFe, CoSm, CoPt, CoMnB, CoFeB. Als isolierende Materialien für die nichtmagnetische Schicht eignen sich zum Beispiel Al₂O₃, MgO, NiO, HfO₂, TiO₂, NbO, SiO₂ und DLC (Diamond-like carbon). Als leitende Materialien für die nichtmagnetische Schicht eignen sich zum Beispiel Cu oder Ag.

Die Dicke der magnetischen Schichten beträgt vorzugsweise zwischen 5nm und 10 nm. Die Dicke der nichtmagnetischen Schicht liegt vorzugsweise im Bereich zwischen 1nm und 3nm. Die Speicherelemente weisen vorzugsweise Abmessungen im Bereich zwischen 50nm und 150nm auf. Sie können unter anderem quadratisch oder langgestreckt ausgestaltet sein.

Zur Erhöhung der Prozeßsicherheit des Verfahrens ist es vorteilhaft, zwischen der Schichtstruktur der Speicherzelle und einer darauf angeordneten metallischen Leitung eine Zwischenschicht anzuordnen. Die Zwischenschicht verhindert eine Beschädigung der Schichtstrukturen der Speicherzelle beim Planarisieren des isolierenden Materials zur Erzeugung der isolierenden Strukturen. Beim Planarisieren wird die Zwischenschicht freigelegt und kann auch etwas abgetragen werden. Die Zwischenschicht kann darüber hinaus zugleich als Diffusionsbarriere wirken.

Die Schichtstruktur des Speicherelements kann auf der Schichtstruktur der Diode angeordnet sein. Alternativ ist die Schichtstruktur der Diode auf der Schichtstruktur des Speicherelements angeordnet.

Im folgenden wird ein mögliches Betriebsverfahren der Speicherzellenanordnung beschreiben.

Zum Schreiben von Information auf eine Speicherzelle werden den mit der Speicherzelle verbundenen metallischen Leitungen Ströme eingeprägt. Ein dadurch erzeugtes Magnetfeld ist im Bereich der Speicherzelle größer als in Bereichen der übrigen Speicherzellen. Das Magnetfeld ist im Bereich der Speicherzelle so groß, daß die Magnetisierung der magnetisch weicheren der beiden magnetischen Schichten des zugehörigen Speicherelements sich im Magnetfeld ausrichtet. Die Magnetisierungsrichtung der magnetisch härteren der beiden magnetischen Schichten bleibt unverändert. Das Magnetfeld wird entsprechend der zu schreibenden Information so eingestellt, daß die Magnetisierungsrichtung der magnetisch weichen Schicht parallel oder antiparallel zur Magnetisierungsrichtung der magnetisch harten Schicht ist. Die Speicherzelle kann folglich zwei verschiedene Magnetisierungszustände einnehmen.

Zum Auslesen der Information der Speicherzelle werden an den zugehörigen metallischen Leitungen Spannungen derart angelegt, daß ein Strom durch die Speicherzelle fließt. Die Höhe des Stroms ist abhängig vom Magnetisierungszustand der Speicherzelle und folglich abhängig von der gespeicherten Information.

Im folgenden wird die Erfindung anhand eines Ausführungsbeispieles, das in den Figuren dargestellt ist, näher erläutert.
- Figur 1: zeigt einen Querschnitt durch ein Substrat mit einem Zwischenoxid, nachdem eine erste Lage metallischer Leitungen, eine erste Metallschicht, eine isolierende Schicht, eine zweite Metallschicht, eine erste magnetische Schicht, eine nichtmagnetische Schicht, eine zweite magnetische Schicht, eine erste Zwischenschicht und erste isolierende Strukturen erzeugt wurden.
- Figur 2a: zeigt den Querschnitt aus Figur 1, nachdem eine zweite Lage metallischer Leitungen, eine dritte Metallschicht, eine zweite isolierende Schicht, eine vierte Metallschicht, eine dritte magnetische Schicht, eine zweite nichtmagnetische Schicht, eine vierte magnetische Schicht, eine zweite Zwischenschicht und zweite isolierende Strukturen erzeugt wurden.
- Figur 2b: zeigt einen zum Querschnitt aus Figur 2a senkrechten Querschnitt durch das Substrat nach den Prozeßschritten aus Figur 2a.
- Figur 3a: zeigt den Querschnitt aus Figur 2a, nachdem eine dritte Lage metallischer Leitungen erzeugt wurden.
- Figur 3b: zeigt den Querschnitt aus Figur 2b nach den Prozeßschritten aus Figur 3a.

Die Figuren sind nicht maßstabsgerecht.

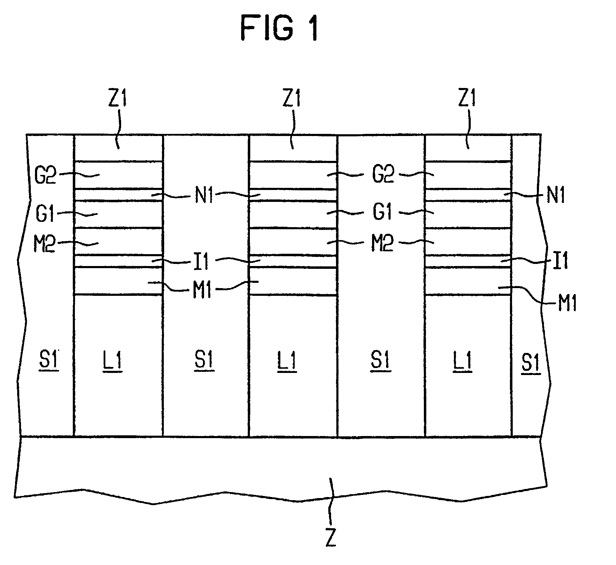

In einem Ausführungsbeispiel ist ein Substrat vorgesehen, in dem Halbleiterbauelemente (nicht dargestellt) angeordnet sind und das von einem Zwischenoxid Z bedeckt ist (siehe Figur 1). Die Halbleiterbauelemente können Teil einer Peripherie einer zu erzeugenden Speicherzellenanordnung sein.

Zur Erzeugung einer ersten leitenden Schicht wird Kupfer in einer Dicke von ca. 500 nm abgeschieden. Zur Erzeugung einer ersten Metallschicht M1 wird Aluminium in einer Dicke von ca. 10 nm abgeschieden. Durch thermische Oxidation wird eine ca. 3 nm dicke erste isolierende Schicht I1 aus Aluminiumoxid erzeugt. Zur Erzeugung einer zweiten Metallschicht M2 wird Platin in einer Dicke von ca. 10 nm abgeschieden. Anschließend wird eine ca. 10 nm dicke erste Diffusionsbarriere (nicht dargestellt) aus Titannitrid abgeschieden. Zur Erzeugung einer ersten magnetischen Schicht G1 wird Kobalt in einer Dicke von ca. 10 nm abgeschieden. Zur Erzeugung einer ca. 3 nm dikken ersten nichtmagnetischen Schicht M1 wird Aluminium abgeschieden und durch thermische Oxidation aufoxidiert. Zur Erzeugung einer zweiten magnetischen Schicht G2 wird NiFe in einer Dicke von ca. 10 nm abgeschieden. Zur Erzeugung einer ersten Zwischenschicht Z1 wird Titannitrid in einer Dicke von ca. 20 nm abgeschieden (siehe Figur 1).

Mit Hilfe einer streifenförmigen ersten Fotolackmaske (nicht dargestellt), deren Streifen ca. 150 nm breit sind und Abstände von ca. 150 nm voneinander aufweisen, werden die erste Zwischenschicht Z1, die zweite magnetische Schicht G2, die erste nichtmagnetische Schicht N1, die erste magnetische Schicht G1, die erste Diffusionsbarriere, die zweite Metallschicht M2, die erste isolierende Schicht I1 und die erste Metallschicht M1 durch Sputtern mit Argon geätzt. Anschließend wird Kupfer mit zum Beispiel BCl₃ + Cl₂ + CH₄ geätzt, so daß aus der ersten leitenden Schicht eine erste Lage metallischer Leitungen L1 erzeugt wird (siehe Figur 1). Die erste Fotolackmaske wird entfernt.

Zur Erzeugung von ersten isolierenden Strukturen S1 wird SiO₂ in einer Dicke von ca. 100 nm abgeschieden und durch chemisch-mechanisches Polieren planarisiert, bis die erste Zwischenschicht Z1 freigelegt wird (siehe Figur 1). Die erste Zwischenschicht Z1 wird dabei um ca. 10 nm abgetragen.

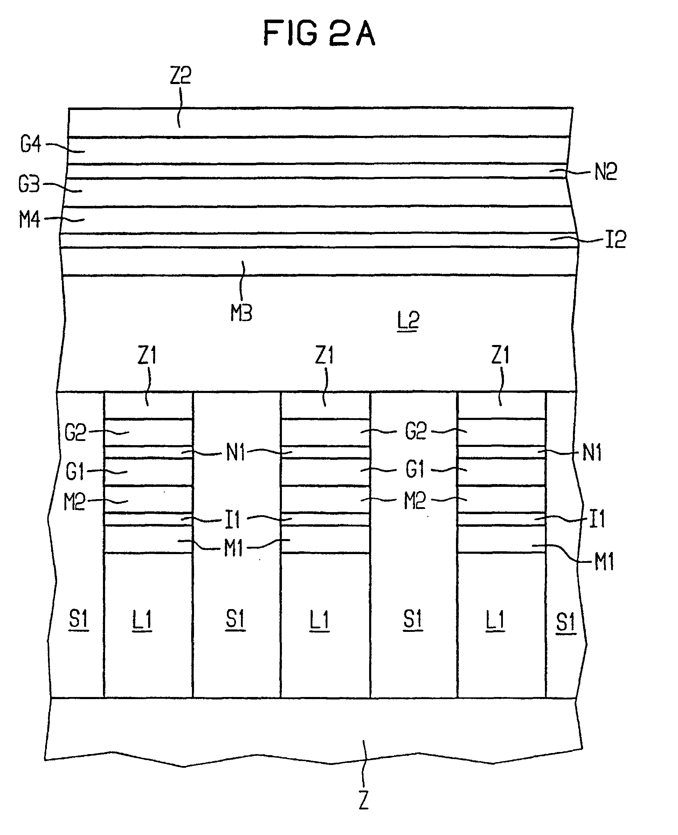

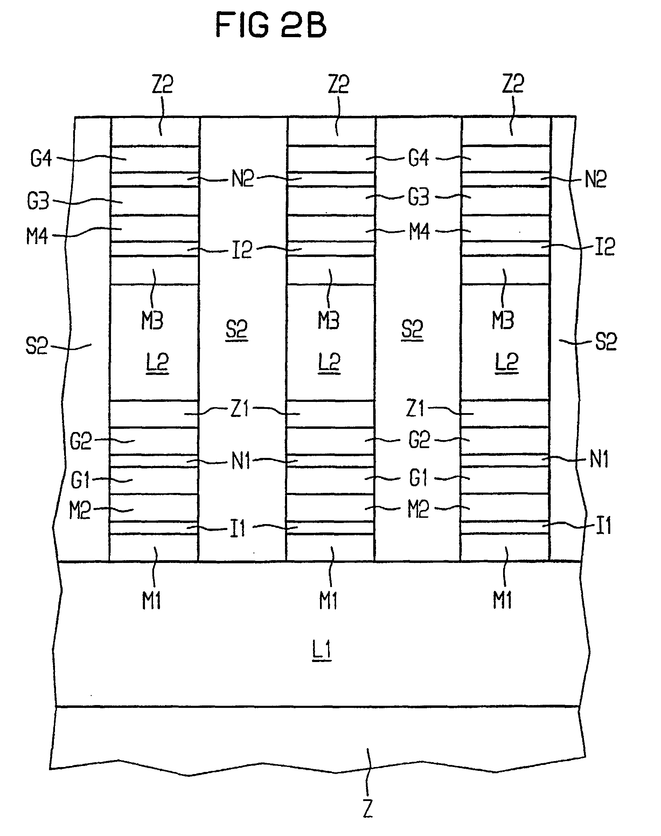

Zur Erzeugung einer zweiten leitenden Schicht wird Kupfer in einer Dicke von ca. 500 nm abgeschieden. Zur Erzeugung einer dritten Metallschicht M3 wird Aluminium in einer Dicke von ca. 10 nm abgeschieden. Durch thermische Oxidation wird eine ca. 3 nm dicke zweite isolierende Schicht I2 aus Aluminiumoxid erzeugt. Zur Erzeugung einer vierten Metallschicht M4 wird Platin in einer Dicke von ca. 10 nm abgeschieden. Zur Erzeugung einer zweiten Diffusionsbarriere (nicht dargestellt) wird Titannitrid in einer Dicke von ca. 10 nm abgeschieden. Zur Erzeugung einer dritten magnetischen Schicht G3 wird Kobalt in einer Dicke von ca. 10 nm abgeschieden. Zur Erzeugung einer ca. 3 nm dicken zweiten nichtmagnetischen Schicht N2 wird Aluminium abgeschieden und durch thermische Oxidation aufoxidiert. Zur Erzeugung einer vierten magnetischen Schicht G4 wird NiFe in einer Dicke von ca. 10 nm abgeschieden. Zur Erzeugung einer zweiten Zwischenschicht Z2 wird TiN in einer Dicke von ca. 20 nm abgeschieden (siehe Figuren 2a und 2b).

Mit Hilfe einer zweiten streifenförmigen Fotolackmaske (nicht dargestellt), deren Streifen ca. 150 nm breit sind, quer zu den Streifen der ersten Fotolackmaske verlaufen und Abstände von ca. 150 nm voneinander aufweisen, werden die zweite Zwischenschicht Z2, die vierte magnetische Schicht G4, die zweite nichtmagnetische Schicht N2, die dritte magnetische Schicht G3, die zweite Diffusionsbarriere, die vierte Metallschicht M4, die zweite isolierende Schicht I2 und die dritte Metallschicht M3 durch Sputtern mit Argon geätzt. Anschließend wird die zweite leitende Schicht mit zum Beispiel BCl₃ + Cl₂ + CH₄ geätzt, so daß eine zweite Lage metallischer Leitungen L2 erzeugt wird (siehe Figuren 2a und 2b).

Anschließend werden die erste Zwischenschicht Z1, die zweite magnetische Schicht G2, die erste nichtmagnetische Schicht N1, die erste magnetische Schicht G1, die erste Diffusionsbarriere, die zweite Metallschicht M2, die erste isolierende Schicht I1 und die erste Metallschicht M1 durch Sputtern mit Argon geätzt. Dadurch entstehen aus der zweiten magnetischen Schicht G2, der ersten nichtmagnetischen Schicht N1 und der ersten magnetischen Schicht G1 voneinander getrennte Schichtstrukturen von Speicherelementen einer ersten Lage von Speicherzellen. Aus der zweiten Metallschicht M2, der ersten isolierenden Schicht I1 und der ersten Metallschicht M1 entstehen Schichtstrukturen von Dioden der ersten Lage der Speicherzellen. Eine Speicherzelle der ersten Lage umfaßt eine Diode und ein Speicherelement, deren Schichtstrukturen übereinander angeordnet sind.

Die zweite Fotolackmaske wird entfernt.

Zur Erzeugung von zweiten isolierenden Strukturen S2 wird SiO₂ in einer Dicke von ca. 100 nm abgeschieden und durch chemisch-mechanisches Polieren planarisiert, bis die zweite Zwischenschicht Z2 freigelegt wird. Die zweite Zwischenschicht Z2 wird dabei ca. 10 nm abgetragen.

Zur Erzeugung einer dritten leitenden Schicht wird Kupfer in einer Dicke von ca. 500 nm abgeschieden.

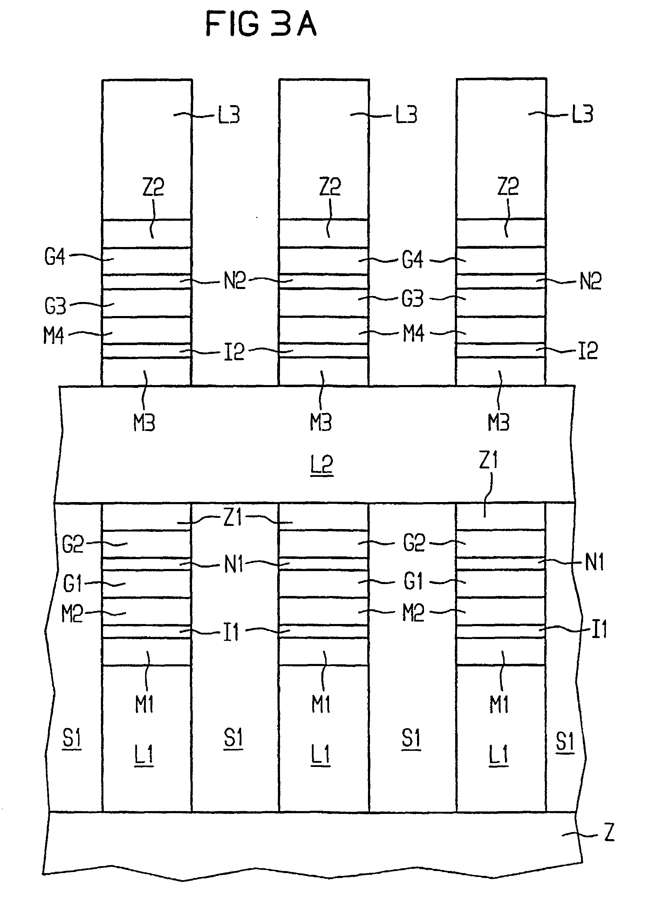

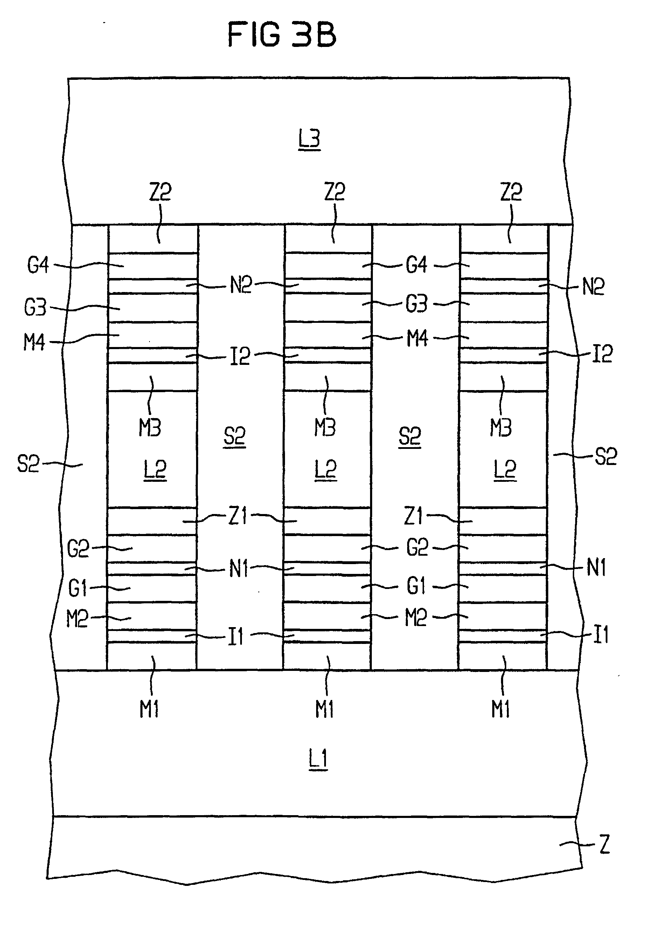

Mit Hilfe einer dritten streifenförmigen Fotolackmaske (nicht dargestellt), die der ersten Fotolackmaske entspricht, wird mit zum Beispiel BCl₃ + CO₂ + CH₄ Kupfer geätzt, so daß aus der dritten leitenden Schicht eine dritte Lage metallischer Leitungen L3 erzeugt wird (siehe Figuren 3a und 3b).

Anschließend werden die zweite Zwischenschicht Z2, die vierte magnetische Schicht G4, die zweite nichtmagnetische Schicht N2, die dritte magnetische Schicht G3, die zweite Diffusionsbarriere, die vierte Metallschicht M4, die zweite isolierende Schicht I2 und die dritte Metallschicht M3 durch Sputtern mit Argon geätzt. Aus der vierten magnetischen Schicht G4, der zweiten nichtmagnetischen Schicht N2 und der dritten magnetischen Schicht G3 entstehen dadurch voneinander getrennte Schichtstrukturen von Speicherelementen einer zweiten Lage von Speicherzellen. Aus der vierten Metallschicht M4, der zweiten isolierenden Schicht I2 und der dritten Metallschicht M3 entstehen Schichtstrukturen der Dioden der Speicherzellen der zweiten Lage. Eine Speicherzelle der zweiten Lage umfaßt eine Diode und ein Speicherelement, deren Schichtstrukturen übereinander angeordnet sind.

Durch das Verfahren wird eine MRAM-Speicherzellenanordnung erzeugt mit zwei übereinander angeordneten Lagen von Speicherzellen.

Es sind viele Variationen des Ausführungsbeispiels denkbar, die ebenfalls im Rahmen der Erfindung liegen. Insbesondere können Abmessungen der beschriebenen Schichten und Masken nach Belieben an die jeweiligen Erfordernisse angepaßt werden. Dasselbe gilt für die Wahl von Materialien.

Die metallischen Leitungen L1, L2, L3 können statt aus Kupfer aus Aluminium erzeugt werden. In diesem Fall wirken als untere Metallschichten der Dioden Teile der metallischen Leitungen. Auf die Erzeugung von separaten Metallschichten M1, M3 kann verzichtet werden.

Es können mehr als drei Lagen metallischer Leitungen und mehr als zwei Lagen von Speicherzellen erzeugt werden, die alternierend übereinander angeordnet sind.

## Patentansprüche

1. Speicherzellenanordnung,
- bei der mindestens drei Lagen metallischer Leitungen (L1, L2, L3) und zwei Lagen von Speicherzellen vorgesehen sind, die alternierend übereinander angeordnet sind,
- bei der die Speicherzellen jeweils eine Diode und ein dazu in Reihe geschaltetes Speicherelement aufweisen,
- bei der das Speicherelement eine Schichtstruktur mit magnetoresistivem Effekt aufweist,
- bei der die Diode eine Schichtstruktur aufweist, die aus mindestens zwei Metallschichten (M1, M2)und aus einer dazwischen angeordneten isolierenden Schicht (I1) besteht,
- bei der die Schichtstruktur des Speicherelements und die Schichtstruktur der Diode übereinander angeordnet sind,
- bei der die metallischen Leitungen (L1) von jeweils einer der Lagen parallel zueinander verlaufen,
- bei der die metallischen Leitungen (Ll, L2) von zueinander benachbarten Lagen quer zueinander verlaufen,
- bei der die Speicherzellen jeweils zwischen eine metallische Leitung (L1, L2) einer Lage und eine metallische Leitung (L2, L3) einer dieser Lage benachbarten Lage geschaltet sind.

2. Speicherzellenanordnung nach Anspruch 1,
- bei der eine der zwei Metallschichten (M1) der Diode Teil einer der metallischen Leitungen (L1) ist.

3. Speicherzellenanordnung nach Anspruch 1 oder 2,
- bei der die Schichtstruktur des Speicherelements mindestens aus zwei magnetischen Schichten (G1, G2) und einer dazwischen angeordneten nichtmagnetischen Schicht (N1) besteht.

4. Verfahren zur Erzeugung einer Speicherzellenanordnung,
- bei dem eine erste Lage metallischer Leitungen (L1), die parallel zueinander verlaufen, erzeugt wird,
- bei dem über der ersten Lage der metallischen Leitungen (L1) eine erste Lage von Speicherzellen so erzeugt wird, daß die Speicherzellen der ersten Lage mit den metallischen Leitungen (L1) der ersten Lage verbunden sind,
- bei dem für die Speicherzellen der ersten Lage jeweils eine Speicherelement und eine dazu in Reihe geschaltete Diode erzeugt werden,
- bei dem für die Diode eine Schichtstruktur erzeugt wird, die aus mindestens zwei Metallschichten (M1, M2) und aus einer dazwischen angeordneten isolierenden Schicht (I1) besteht,
- bei dem für das Speicherelement eine Schichtstruktur mit magnetoresistivem Effekt erzeugt wird,
- bei dem die Schichtstruktur des Speicherelements und die Schichtstruktur der Diode übereinander erzeugt werden,
- bei dem über der ersten Lage der Speicherzellen eine zweite Lage metallischer Leitungen (L2), die parallel zueinander und quer zu den metallischen Leitungen (L1) der ersten Lage verlaufen, so erzeugt wird, daß die Speicherzellen der ersten Lage jeweils zwischen eine metallische Leitung (L1) der ersten Lage und eine metallische Leitung (L2) der zweiten Lage geschaltet sind,
- bei dem über der zweiten Lage der metallischen Leitungen (L2) entsprechend den Speicherzellen der ersten Lage aufgebaute Speicherzellen einer zweiten Lage erzeugt werden,
- bei dem über der zweiten Lage der Speicherzellen eine dritte Lage metallischer Leitungen (L3), die parallel zueinander und quer zu den metallischen Leitungen (L2) der zweiten Lage verlaufen, so erzeugt wird, daß die Speicherzellen der zweiten Lage jeweils zwischen eine metallische Leitung (L2) der zweiten Lage und eine metallische Leitung (L3) der dritten Lage geschaltet sind.

5. Verfahren nach Anspruch 4,
- bei dem eine erste leitende Schicht und darüber Schichten (M1, I1, M2, G1, N1, G2) zur Erzeugung der ersten Lage der Speicherzellen erzeugt werden,
- bei dem die Schichten (M1, I1, M2, G1 N1, G2) zur Erzeugung der ersten Lage der Speicherzellen und die erste leitende Schicht mit Hilfe einer ersten streifenförmigen Maske so strukturiert werden, daß aus der ersten Schicht die erste Lage der metallischen Leitungen (L1) erzeugt wird,
- bei dem isolierendes Material abgeschieden und planarisiert wird, so daß voneinander getrennte streifenförmige erste isolierende Strukturen (S1) erzeugt werden,
- bei dem eine zweite leitende Schicht und darüber Schichten (M3, I2, M4, G3, N2, G4) zur Erzeugung der zweiten Lage der Speicherzellen aufgebracht werden,
- bei dem die Schichten (M3, I2, M4, G3, N2, G4) zur Erzeugung der zweiten Lage der Speicherzellen, die zweite leitende Schicht und die Schichten (M1, I1, M2, G1, N1, G2) zur Erzeugung der ersten Lage der Speicherzellen mit Hilfe einer streifenförmigen zweiten Maske so strukturiert werden, daß aus der zweiten Schicht die zweite Lage der metallischen Leitungen (L2) erzeugt wird, und daß aus den Schichten (M1, I1, M2, G1, N1, G2) zur Erzeugung der ersten Lage der Speicherzellen die Speicherzellen der ersten Lage erzeugt werden,
- bei dem isolierendes Material abgeschieden und planarisiert wird, so daß voneinander getrennte streifenförmige zweite isolierende Strukturen (S2) erzeugt werden,
- bei dem eine dritte leitende Schicht aufgebracht wird,
- bei dem die dritte Schicht und die Schichten (M3, I2, M4, G3, N2, G4) zur Erzeugung der zweiten Lage der Speicherzellen mit Hilfe einer streifenförmigen dritten Maske so strukturiert werden, daß aus der dritten Schicht die dritte Lage der metallischen Leitungen (L3) erzeugt wird, und daß aus den Schichten (M3, I2, M4, G3, N2, G4) zur Erzeugung der zweiten Lage der Speicherzellen die Speicherzellen der zweiten Lage erzeugt werden.

6. Verfahren nach Anspruch 4 oder 5,
- bei dem eine der zwei Metallschichten (M1) der Diode als Teil einer der metallischen Leitungen (L1) erzeugt wird.

7. Verfahren nach einem der Ansprüche 4 bis 6,
- bei dem für die Schichtstruktur des Speicherelements mindestens zwei magnetische Schichten (G1, G2) und eine dazwischen angeordnete nichtmagnetische Schicht (N1) erzeugt werden.

## Claims

1. Memory cell arrangement,
- in which at least three layers of metallic lines (L1, L2, L3) and two layers of memory cells are provided, which are arranged alternately one above the other,
- in which the memory cells, each have a diode and a memory element connected in series therewith,
- in which the memory element has a layer structure with a magnetoresistive effect,
- in which the diode has a layer structure comprising at least two metal layers (M1, M2) and an insulating layer (I1) arranged in between,
- in which the layer structure of the memory element and the layer structure of the diode are arranged above one another,
- in which the metallic lines (L1) of a respective one of the layers run parallel to one another,
- in which the metallic lines (L1, L2) of mutually adjacent layers run transversely with respect to one another,
- in which the memory cells are in each case connected between a metallic line (L1, L2) of one layer and a metallic line (L2, L3) of a layer adjacent to this layer.

2. Memory cell arrangement according to Claim 1,
- in which one of the two metal layers (M1) of the diode is part of one of the metallic lines (L1).

3. Memory cell arrangement according to Claim 1 or 2,
- in which the layer structure of the memory element at least comprises two magnetic layers (G1, G2) and a nonmagnetic layer (N1) arranged in between.

4. Method for producing a memory cell arrangement,
- in which a first layer of metallic lines (L1) which run parallel to one another is produced,
- in which a first layer of memory cells is produced above the first layer of metallic lines (L1) in such a way that the memory cells of the first layer are connected to the metallic lines (L1) of the first layer,
- in which a memory element and a diode connected in series therewith are in each case produced for the memory cells of the first layer,
- in which, for the diode, a layer structure is produced which comprises at least two metal layers (M1, M2) and an insulating layer (I1) arranged in between,
- in which a layer structure with a magnetoresistive effect is produced for the memory element,
- in which the layer structure of the memory element and the layer structure of the diode are produced above one another,
- in which a second layer of metallic lines (L2), which run parallel to one another and transversely with respect to the metallic lines (L1) of the first layer, is produced above the first layer of memory cells in such a way that the memory cells of the first layer are in each case connected between a metallic line (L1) of the first layer and a metallic line (L2) of the second layer,
- in which memory cells of a second layer which are constructed in accordance with the memory cells of the first layer are produced above the second layer of metallic lines (L2),
- in which a third layer of metallic lines (L3), which run parallel to one another and transversely with respect to the metallic lines (L2) of the second layer, is produced above the second layer of memory cells in such a way that the memory cells of the second layer are in each case connected between a metallic line (L2) of the second layer and a metallic line (L3) of the third layer.

5. Method according to Claim 4,
- in which a first conductive layer and, above the latter, layers (M1, I1, M2, G1, N1, G2) for producing the first layer of memory cells are produced,
- in which the layers (M1, I1, M2, G1, N1, G2) for producing the first layer of memory cells and the first conductive layer are patterned with the aid of a first strip-type mask in such a way that the first layer of metallic lines (L1) is produced from the first layer,
- in which insulating material is deposited and planarized, thereby producing mutually separate strip-type first insulating structures (S1),
- in which a second conductive layer and, above the latter, layers (M3, I2, M4, G3, N2, G4) for producing the second layer of memory cells are applied,
- in which the layers (M3, I2, M4, G3, N2, G4) for producing the second layer of memory cells, the second conductive layer and the layers (M1, I1, M2, G1, N1, G2) for producing the first layer of memory cells are patterned with the aid of a strip-type second mask in such a way that the second layer of metallic lines (L2) is produced from the second layer, and that the memory cells of the first layer are produced from the layers (M1, I1, M2, G1, N1, G2) for producing the first layer of memory cells,
- in which insulating material is deposited and planarized, thereby producing mutually separate strip-type second insulating structures (S2),
- in which a third conductive layer is applied,
- in which the third layer and the layers (M3, I2, M4, G3, N2, G4) for producing the second layer of memory cells are patterned with the aid of a strip-type third mask in such a way that the third layer of metallic lines (L3) is produced from the third layer, and that the memory cells of the second layer are produced from the layers (M3, I2, M4, G3, N2, G4) for producing the second layer of memory cells.

6. Method according to Claim 4 or 5,
- in which one of the two metal layers (M1) of the diode is produced as part of one of the metallic lines (L1).

7. Method according to one of Claims 4 to 6,
- in which at least two magnetic layers (G1, G2) and a nonmagnetic layer (N1) arranged in between are produced for the layer structure of the memory element.

## Revendications

1. Dispositif de cellules de mémoire
- dans lequel il est prévu au moins trois strates de conducteur (L1, L2, L3) métalliques et deux strates de cellules de mémoire qui sont superposées en alternance,
- dans lequel les cellules de mémoire ont respectivement une diode et un élément de mémoire monté en série avec celle-ci,
- dans lequel l'élément de mémoire a une structure stratifiée ayant un effet magnétorésistant,
- dans lequel la diode a une structure stratifiée constituée d'au moins deux couches (M1, M2) métalliques et d'une couche (I1) isolante interposée entre elles,
- dans lequel la structure stratifiée de l'élément de mémoire et la structure stratifiée de la diode sont disposées l'une au-dessus de l'autre,
- dans lequel les conducteurs (L1) métalliques de respectivement l'une des strates s'étendent parallèlement les uns aux autres,
- dans lequel les conducteurs (L1, L2) métalliques de strates voisines l'une de l'autre s'étendent transversalement les uns aux autres,
- dans lequel les cellules de mémoire sont montées respectivement entre un conducteur (L1, L2) métallique d'une strate et un conducteur (L2, L3) métallique d'une strate voisine de cette strate,

2. Dispositif de cellules de mémoire suivant la revendication 1
- dans lequel l'une des couches (M1) métalliques de la diode fait partie de l'un des conducteurs (L1) métalliques.

3. Dispositif de cellules de mémoire suivant la revendication 1 ou 2,
- dans lequel la structure stratifiée de l'élément de mémoire, est constituée d'au moins deux couches (G1, G2) magnétiques et d'une couche (N1) amagnétique interposée entre elles.

4. Procédé de production d'un dispositif de cellules de mémoire
- dans lequel on produit une première strate de conducteurs (L1) métalliques qui s'étendent parallèlement entre eux,
- dans lequel on produit sur la première strate des conducteurs (L1) métalliques une première strate de cellules de mémoire, de façon à ce que les cellules de mémoire de la première strate soient reliées aux lignes (L1) métalliques de la première strate,
- dans lequel on produit pour les cellules de mémoire de la première strate respectivement un élément de mémoire et une diode montée en série avec celui-ci,
- dans lequel on produit pour la diode une structure stratifiée constituée d'au moins deux couches (M1, M2) métalliques et d'une couche (I1) isolante interposée entre elles,
- dans lequel on produit pour l'élément de mémoire une structure stratifiée à effet magnétorésistant,
- dans lequel on produit l'une sur l'autre la structure stratifiée de l'élément de mémoire et la structure stratifiée de la diode,
- dans lequel on produit au-dessus de la première strate des cellules de mémoire une deuxième strate de conducteurs (L2) métalliques qui s'étendent parallèlement les uns aux autres et transversalement aux conducteurs (L1) métalliques de la première strate, de façon à ce que les cellules de mémoire de la première strate soient montées respectivement entre un conducteur (L1) métallique de la première strate et un conducteur (L2) métallique de la deuxième strate,
- dans lequel on produit au-dessus de la deuxième strate des conducteurs (L2) métalliques des cellules de mémoire d'une deuxième strate constituées de manière correspondante aux cellules de mémoire de la première strate,
- dans lequel on produit au-dessus de la deuxième strate des cellules de mémoire une troisième strate de conducteurs (L3) métalliques qui s'étendent parallèlement entre eux et transversalement aux lignes (L2) métalliques de la deuxième strate, de façon à ce que les cellules de mémoire de la deuxième strate soient montées respectivement entre un conducteur (L2) métallique de la deuxième strate et un conducteur (L3) métallique de la troisième strate.

5. Procédé suivant la revendication 4,
- dans lequel on produit une première couche conductrice et au-dessus des couches (M1, I1, M2, G1, N1, G2) de production de la première strate des cellules de mémoire,
- dans lequel on structure les couches (M1, I1, M2, G1, N1, G2) de production de la première strate des cellules de mémoire et la première couche conductrice à l'aide d'un masque en forme de bandess, de façon à produire à partir de la première couche, la première strate des conducteurs (L1) métalliques,
- dans lequel on dépose et on rend plan la matière isolante de façon à produire des première structures (S1) isolantes en forme de bandes qui sont séparées les unes des autres,
- dans lequel on dépose une deuxième couche conductrice et au-dessus des couches (M3, I2, M4, G3, N2, G4) de production de la deuxième strate des cellules de mémoire,
- dans lequel on structure les couches (M3, I2, M4, G3, N2, G4) de production de la deuxième strate des cellules de mémoire, la deuxième couche conductrice et les couches (M1, I1, M2, G1, N1, G2) de production de la première strate des cellules de mémoire à l'aide d'un deuxième masque en forme de bandes de façon à produire à partir de la deuxième couche la deuxième strate des conducteurs (L2) métalliques et à produire à partir des couches (M1, I1, M2, G1, N1, G2) de production de la première strate des cellules de mémoire, les cellules de mémoire de la première couche,
- dans lequel on dépose et on rend plan la matière isolante de façon à produire des deuxièmes structures (S2) isolantes en forme de bandes, qui sont séparées les unes des autres,
- dans lequel on dépose une troisième couche conductrice,
- dans lequel on structure la troisième couche et les couches (M3, I2, M4, G3, N2, G4) de production de la deuxième strate des cellules de mémoire à l'aide d'un troisième masque en forme de bandes de façon à produire à partir de la troisième couche la troisième strate des conducteurs (L3) métalliques et de façon à produire à partir des couches (M3, 12, M4, G3, N2, G4) de production de la deuxième strate des cellules de mémoire, les cellules de mémoire de la deuxième strate.

6. Procédé suivant la revendication 4 ou 5,
- dans lequel on produit l'une des deux couches (M1) métalliques de la diode en tant que partie de l'un des conducteurs (L1) métalliques.

7. Procédé suivant l'une des revendications 4 à 6
- dans lequel on produit pour la structure stratifiée des éléments de mémoire au moins deux couches (G1, G1) magnétiques et une couche (N1) amagnétique interposée entre elles.
